(19) **Europäisches Patentamt / European Patent Office / Office européen des brevets**

(11) **EP 1 014 560 B1**

(12) **FASCICULE DE BREVET EUROPEEN**

(45) Date de publication et mention de la délivrance du brevet:
**26.11.2008 Bulletin 2008/48**

(51) Int Cl.:
***H03C 3/09*** (2006.01)

(21) Numéro de dépôt: **99204192.1**

(22) Date de dépôt: **07.12.1999**

(54) **Appareil radioélectrique comportant un synthétiseur de fréquences et procédé pour moduler en phase et/ou en fréquence un synthétiseur de fréquences.**

Funkgerät mit einem Frequenzsynthetisierer und Verfahren zur Phasen- und/oder Frequenzmodulation in einem Frequenzsynthetisierer

Radio apparatus including a frequency synthesizer and method for phase and/or frequency modulation in a frequency synthesizer

(84) Etats contractants désignés:
**DE FR GB IT**

(30) Priorité: **15.12.1998 FR 9815838**

(43) Date de publication de la demande:
**28.06.2000 Bulletin 2000/26**

(73) Titulaire: **NXP B.V.**
**5656 AG Eindhoven (NL)**

(72) Inventeur: **Chabas, Jean Alain**
**75008 Paris (FR)**

(74) Mandataire: **van der Veer, Johannis Leendert et al**
**NXP Semiconductors B.V.**
**IP&L Department**
**High Tech Campus 32**
**5656 AE Eindhoven (NL)**

(56) Documents cités:
**US-A- 4 321 706**     **US-A- 4 347 484**
**US-A- 4 409 563**     **US-A- 5 734 302**

• **ANDERSEN B E ET AL: "RF SIGNAL GENERATOR SINGLE-LOOP FREQUENCY SYNTHESIS, PHASE NOISE REDUCTION, AND FREQUENCY MODULATION" HEWLETT-PACKARD JOURNAL, vol. 40, no. 5, 1 octobre 1989 (1989-10-01), pages 27-33, XP000087209**

**Description**

La présente invention concerne un appareil radioélectrique comportant un synthétiseur de fréquences pour fournir des signaux de fréquences synthétisées, ce synthétiseur étant muni d'une commande de modulation en phase et/ou en fréquence pour recevoir un signal présentant une largeur de bande dite bande de modulation et étant formé par au moins deux boucles d'asservissement.

L'invention concerne aussi un procédé pour moduler en phase et/ou en fréquence un synthétiseur de fréquences.

De tels appareils sont bien connus et trouvent de nombreuses applications, notamment dans le domaine des appareils de téléphonie portables qui utilisent une multitude de canaux de fréquences déterminés par le synthétiseur. On rappelle qu'un synthétiseur se compose essentiellement d'un oscillateur variable à commande par tension destiné à être asservi, au moyen d'une boucle d'asservissement en phase, sur une fréquence provenant d'un oscillateur de référence. Un diviseur de fréquence est prévu pour déterminer finalement la fréquence de sortie du synthétiseur.

Un des problèmes avec lequel on est confronté est la possibilité de moduler la fréquence et/ou la phase de l'oscillateur variable. En effet la présence de la boucle de verrouillage de phase vient contrebalancer la modulation, de sorte que cette modulation est difficile à appliquer. En outre, on est aussi confronté au problème du bruit de phase qu'engendrent les diviseurs numériques de fréquences que comportent habituellement les synthétiseurs travaillant à fréquence élevée, par exemple dans la bande des 800 MHz.

Il est connu du brevet des Etats-Unis d'Amérique 4 409 563 de prévoir deux boucles pour piloter l'oscillateur variable : une boucle comportant un discriminateur de fréquences et une autre boucle comportant un discriminateur de phase. La boucle munie d'un discriminateur de fréquences est utilisée, lors d'un changement de fréquence ou au démarrage, pour favoriser le blocage de 'oscillateur variable sur l'oscillateur de référence de sorte que la boucle comportant un discriminateur de phase peut verrouiller facilement l'oscillateur variable. Ce dispositif connu n'est pas du tout confronté au problème de la modulation de l'oscillateur variable.

L'invention propose un appareil dans lequel sont prévus des moyens pour la fréquence et/ou la phase de l'oscillateur variable tout en maintenant un verrouillage en phase satisfaisant et tout en assurant un niveau de bruit de phase réduit.

La revendication 1 définit un synthétiseur de fréquences selon l'invention.
Grâce à l'invention, la fréquence de base du synthétiseur est verrouillée par une boucle d'asservissement comprenant un filtre passe-bas, cette boucle n'agissant pas sur des signaux de modulation se produisant à une fréquence plus élevée. Le bruit de phase est atténué par une boucle d'asservissement comprenant un filtre passe-haut.
La description suivante, faite en regard des dessins ci-annexés, le tout donné à titre d'exemple non limitatif, fera bien comprendre comment l'invention peut être réalisée.

La figure 1 montre un appareil conforme à l'invention.
La figure 2 montre le schéma d'un synthétiseur faisant partie de l'appareil de la figure 1.
La figure 3 montre le schéma d'autres modes de réalisation d'un synthétiseur, conformément à l'invention.

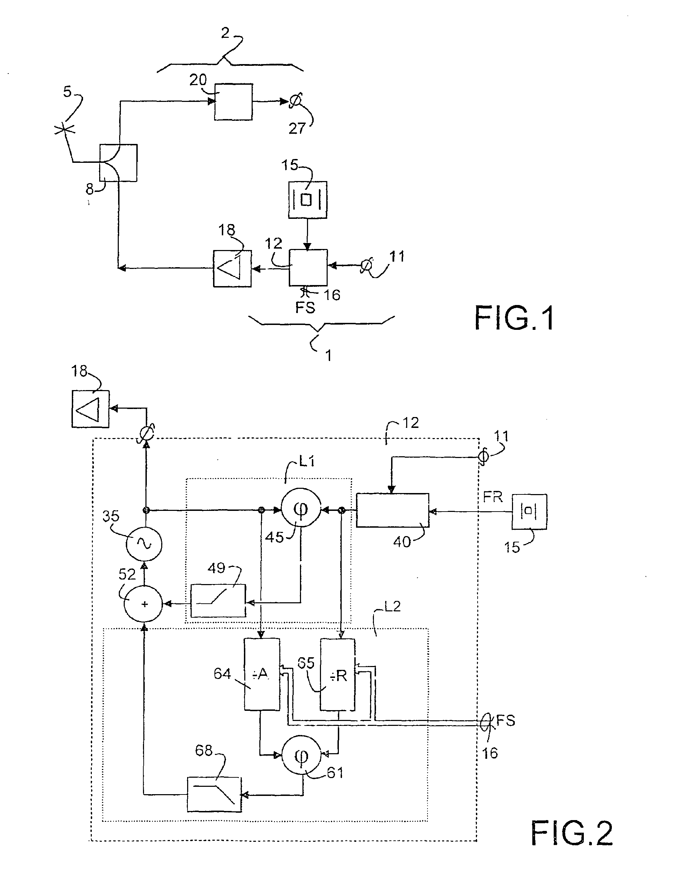

A la figure 1, on a représenté un appareil radioélectrique conforme à l'invention. Cet appareil est un émetteur-récepteur du type prévu pour les radiotéléphones portables, par exemple. Il est composé d'une chaîne d'émission 1 et d'une chaîne de réception 2 couplées à une antenne 5 par l'intermédiaire d'un duplexeur 8. La chaîne d'émission 1 est constituée par une borne d'entrée 11 pour recevoir des signaux de modulation. Cette modulation module en phase et/ou en fréquence une porteuse fournie par un synthétiseur de fréquence 12. Ce synthétiseur utilise les signaux de fréquence FR élaborés par un générateur de fréquence de référence 15 afin de fournir les signaux à une fréquence FS, définie par l'utilisation, à l'aide de la commande de fréquence 16. Le signal de sortie du synthétiseur 12 est ensuite amplifié par un amplificateur 18 avant d'être appliqué à l'antenne 5. La chaîne de réception 2 se compose d'un système de réception 20 pour fournir des informations à une borne de sortie 27.
La figure 2 montre la structure du synthétiseur 12 réalisé conformément à l'invention. Il se compose d'un oscillateur variable à commande par tension 35 dont la sortie est reliée à l'amplificateur 18. Le signal de modulation appliqué sur la borne 11 agit sur un modulateur de phase 40 branché, selon une possibilité, à la sortie du générateur de fréquence de référence 15. Ce synthétiseur 12 comporte une première boucle L1. Cette boucle L1 est constituée par un discriminateur de phase 45 dont une entrée est reliée à la sortie de l'oscillateur variable 35 et l'autre à la sortie du modulateur 40. Le signal d'écart entre les phases des signaux de sortie de l'oscillateur 35 et du modulateur 40 est appliqué à la commande de fréquence par tension de 'oscillateur variable 35, par l'intermédiaire d'un filtre passe-haut 49 et d'un additionneur 52.

Il est prévu une deuxième boucle L2 formée d'un deuxième discriminateur de phase 61 dont les entrée sont reliées aussi aux sorties de l'oscillateur 35 et du modulateur 40, par l'intermédiaire éventuellement de diviseurs 64 et 65 divisant par un nombre A et R respectivement. Ces nombres dépendent de la fréquence désirée FS dont la valeur est appliquée à la commande 16. La sortie de ce discriminateur 61 est reliée aussi à la commande de fréquence par tension de l'oscillateur variable 35, par l'intermédiaire d'un filtre 68 et par l'intermédiaire de l'additionneur 52 qui combine ainsi l'action des deux boucles L1 et L2. Selon l'invention le filtre 68 est un filtre passe-bas.

La fréquence du signal fourni par ce synthétiseur est donc : $FS = \dfrac{A}{R} FR$ .

Ainsi grâce à la boucle L1 l'oscillateur 35 est verrouillé sur la fréquence de référence sur une large bande. On remarquera que la boucle L1 ne comporte pas de diviseur de fréquence qui amène du bruit.

La boucle L2 peut fonctionner à une fréquence bien plus faible que la fréquence de modulation, ce qui fait que cette fréquence de modulation ne sera pas contrariée par cette boucle L2 qui maintiendra la fréquence porteuse du signal de sortie du synthétiseur.

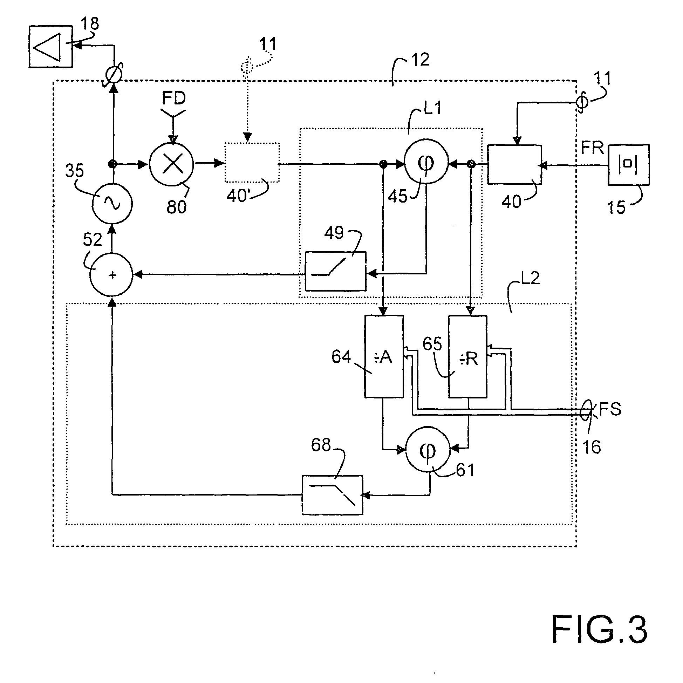

La figure 3 donne d'autres modes de réalisation de l'invention. Sur cette figure les éléments communs avec ceux des figures précédentes portent les mêmes références.

Un première mode de réalisation consiste à mettre le modulateur de phase et/ou de fréquence à l'autre entrée du discriminateur de phase 45. Il est représenté en pointillé sur la figure et porte la référence 40'. Il est aussi possible d'avoir deux tels modulateurs.

Un deuxième mode consiste à prévoir un mélangeur 80 intercalé entre la sortie de l'oscillateur 35 et le discriminateur 45. Ainsi on abaisse la fréquence de fonctionnement de la première boucle sans trop introduire de bruit. En effet les diviseurs de fréquences sont considérés comme apportant trop de bruit.

A titre d'exemple, pour des fréquences à fournir de l'ordre de 800 MHz, la boucle d'asservissement passe-bas a une bande passante de 0 à 1 kHz, alors que la boucle d'asservissement passe-haut a une bande passante allant pratiquement de 1 kHz à 300 kHz. La fréquence de modulation doit alors être supérieure à la fréquence de coupure de la boucle passe-bas c'est-à-dire de 1 kHz.

**Revendications**

1. Synthétiseur de fréquences (12) pour fournir des signaux de fréquences synthétisées, ce synthétiseur comprenant:

   - une commande de modulation (11) en phase et/ou en fréquence pour recevoir un signal présentant une largeur de bande dite bande de modulation, et
   - au moins deux boucles d'asservissement (L1, L2) agissant en combinaison sur un oscillateur à fréquence variable (35), l'une des deux boucles d'asservissement étant une boucle d'asservissement en phase (L2) comprenant un filtre passe-bas (68) disposé entre un discriminateur de phase (61) et l'oscillateur à fréquence variable (35), le discriminateur de phase (61) étant agencé pour effectuer une comparaison des phases provenant respectivement de l'oscillateur à fréquence variable (35) et un générateur de fréquence de référence (15),

**caractérisé en ce que**

   - le filtre passe-bas (68) a une fréquence de coupure inférieure à ladite bande de modulation,

et **en ce que** :

   - l'autre des deux boucles d'asservissement est une boucle d'asservissement en phase (L1) comprenant un filtre passe-haut (49) disposé entre un discriminateur de phase supplémentaire (45) et l'oscillateur à fréquence variable (35), le discriminateur de phase supplémentaire (45) étant également agencé pour effectuer une comparaison des phases provenant respectivement de l'oscillateur à fréquence variable (35) et le générateur de fréquence de référence (15).

2. Synthétiseur selon la revendication 1, **caractérisé en ce qu'**il est prévu un modulateur (40) de fréquence et/ou de phase relié à la sortie du générateur de fréquence de référence (15) pour recevoir ladite commande de modulation (11).

3. Synthétiseur selon la revendication 1 ou 2, **caractérisé en ce qu'**il est prévu un modulateur (40') de fréquence et/ou de phase relié à la sortie de l'oscillateur à fréquence variable (35) pour recevoir ladite commande de modulation.

4. Synthétiseur selon l'une des revendications 1 à 3, **caractérisé en ce que** le synthétiseur comporte un circuit mélangeur (80) pour changer la fréquence de l'oscillateur à fréquence variable (35) à l'intérieur de l'une des boucles d'asservissement en phase.

5. Appareil radioélectrique comprenant un synthétiseur de fréquences selon l'une des revendications précédentes.

**Claims**

1. A frequency synthesizer (12) for producing synthesized frequency signals, this synthesizer comprising:

   - a phase and/or a frequency modulation control (11) for receiving a signal that presents a bandwidth called modulation bandwidth, and
   - at least two phase locked loops (L1, L2) in combination acting on a variable frequency oscillator (35), one of the two phase locked loops being a phase locked loop (L2) that comprises a low-pass filter (68) disposed between a phase discriminator (61) and the variable frequency oscillator (35), the phase discriminator (61) being arranged for effecting a comparison of the phases coming from the variable frequency oscillator (35) and a reference frequency generator (15) respectively,

**characterized in that**

- the low-pass filter (68) has a cut-off frequency that is lower than said modulation band, and **in that**
- the other one of the two phase locked loops is a phase locked loop (L1) that comprises a high-pass filter (49) disposed between an additional phase discriminator (45) and the variable frequency oscillator (35), the additional phase discriminator (45) also being arranged for effecting a comparison of the phases coming from the variable frequency oscillator (35) and the reference frequency generator (15) respectively.

**2.** A synthesizer as claimed in claim 1, **characterized in that** a frequency and/or phase modulator (40) is provided connected to the output of the reference frequency generator (15) for receiving said modulation control (11).

**3.** A synthesizer as claimed in claim 1 or 2, **characterized in that** a frequency and/or phase modulator (40') is provided connected to the output of said variable frequency oscillator (35) for receiving said modulation control.

**4.** A synthesizer as claimed in any one of the claims 1 to 3, **characterized in that** the synthesizer comprises a mixer circuit (80) for changing the frequency of the variable frequency oscillator (35) in one of the phase locked loops.

**5.** A radio apparatus comprising a frequency synthesizer as claimed in any one of the preceding claims.

**Patentansprüche**

**1.** Frequenzsynthetisierer (12) zur Lieferung synthetisierter Frequenzsignale, der folgendes umfasst:

- eine Modulationssteuerung (11) in Phase und/oder Frequenz zur Aufnahme eines Signals mit einer als Modulationsband bezeichneten Bandbreite, und
- zumindest zwei Regelungsschleifen (L1, L2), die im Verband auf einen variablen Frequenzoszillators (35) wirken, wobei eine der beiden Regelungsschleifen eine Regelungsschleife in Phase (L2) ist, die einen Tiefpassfilter (68) umfasst, der zwischen einem Phasendiskriminator (61) und dem variablen Frequenzoszillators (35) angeordnet ist, wobei der Phasendiskriminator (61) für den Vergleich der Phasen ausgelegt ist, die jeweils vom variablen Frequenzoszillator (35) und einem Bezugsfrequenzgenerator (15) stammen,

**dadurch gekennzeichnet, dass**

- der Tiefpassfilter (68) eine Trennfrequenz aufweist, die kleiner als das genannte Modulationsband ist,

und dadurch, dass

- die andere der beiden Regelungsschleifen eine Regelungsschleife in Phase (L1) ist, die einen Hochpassfilter (49) umfasst, der zwischen einem zusätzlichen Phasendiskriminator (45) und dem variablen Frequenzoszillator (35) angeordnet ist, wobei der zusätzliche Phasendiskriminator (45) ebenfalls für den Vergleich der Phasen ausgelegt ist, die jeweils vom variablen Frequenzoszillator (35) und vom Bezugsfrequenzgenerator (15) stammen.

**2.** Synthetisierer nach Anspruch 1, **dadurch gekennzeichnet, dass** ein Frequenz- und/oder Phasenmodulator (40) vorgesehen ist, der mit dem Ausgang des Bezugsfrequenzgenerators (15) verbunden ist, um diese Modulationssteuerung (11) aufzunehmen.

**3.** Synthetisierer nach Anspruch 1 oder 2, **dadurch gekennzeichnet, dass** ein Frequenz- und/oder Phasenmodulator (40') vorgesehen ist, der mit dem Ausgang des variablen Frequenzoszillators (35) verbunden ist, um diese Modulationssteuerung aufzunehmen.

**4.** Synthetisierer nach einem der Ansprüche 1 bis 3, **dadurch gekennzeichnet, dass** der Frequenzsynthetisierer einen Mischkreis (80) umfasst, um die Frequenz des Oszillators mit variabler Frequenz (35) innerhalb einer der Regelungsschleifen in Phase zu ändern.

**5.** Funkgerät, das einen Frequenzsynthetisierer nach einem der vorstehenden Ansprüche umfasst.

FIG.1

FIG.2

FIG.3